(19) Europäisches Patentamt / European Patent Office / Office européen des brevets

(11) **EP 4 641 622 B1**

(12) **EUROPEAN PATENT SPECIFICATION**

(45) Date of publication and mention
of the grant of the patent:
**24.06.2026 Bulletin 2026/26**

(21) Application number: **25160806.3**

(22) Date of filing: **28.02.2025**

(51) International Patent Classification (IPC):
*H10W 70/40* (2026.01)     *H10W 72/00* (2026.01)
*H10W 70/04* (2026.01)     *H10W 72/60* (2026.01)
*H10W 74/01* (2026.01)     *H10W 74/10* (2026.01)
*H10W 90/00* (2026.01)     *H10W 74/00* (2026.01)

(52) Cooperative Patent Classification (CPC):
**H10W 74/014; H10W 70/048; H10W 70/421;
H10W 70/424; H10W 70/457; H10W 70/466;
H10W 74/111;** H10W 72/0198; H10W 72/07336;
H10W 72/07636; H10W 72/07637; H10W 72/07653;
H10W 72/651; H10W 72/652; H10W 72/871;
(Cont.)

(54) **MANUFACTURING METHOD OF NO-LEAD SEMICONDUCTOR PACKAGE COMPONENT**

HERSTELLUNGSVERFAHREN FÜR HALBLEITERGEHÄUSE-KOMPONENTE OHNE HERVORSTEHENDE ANSCHLÜSSE

PROCÉDÉ DE FABRICATION D'UN COMPOSANT DE BOÎTIER DE SEMI-CONDUCTEUR SANS BROCHES

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**

(30) Priority: **26.04.2024 CN 202410511515**

(43) Date of publication of application:
**29.10.2025 Bulletin 2025/44**

(73) Proprietor: **Panjit Electronics (Wuxi) Co., Ltd.
Jiangsu 214028 (CN)**

(72) Inventors:
• **FANG, Jeff**
**Jiangsu, 214028 (CN)**

• **HSIA, Cheng-Yu**
**Jiangsu, 214028 (CN)**
• **BAI, Guangyu**
**Jiangsu, 214028 (CN)**

(74) Representative: **Müller Schupfner & Partner
Patent- und Rechtsanwaltspartnerschaft mbB (Muc)
Bavariaring 11
80336 München (DE)**

(56) References cited:
CN-A- 115 172 320     JP-A- 2017 228 559
US-A1- 2014 225 239    US-A1- 2016 126 162
US-A1- 2017 271 249    US-A1- 2019 244 928
US-A1- 2023 395 451

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

(52) Cooperative Patent Classification (CPC): (Cont.)
H10W 74/00; H10W 90/726; H10W 90/736;
H10W 90/756; H10W 90/766

## Description

## Technical Field

The disclosure relates to the technical field of a semiconductor package component, more particularly to the technical field of a no-lead semiconductor package component.

## Background

A Quad Flat No-lead Package (QFN) uses a traditional lead frame and is an advanced package component similar to a Chip Size Package (CSP). It uses dual or quad flat no-lead package techniques having soldering pads only on a bottom part and two sides and having advantages of small volume, light weight, excellent heat dissipation, excellent electrical performance and high reliability.

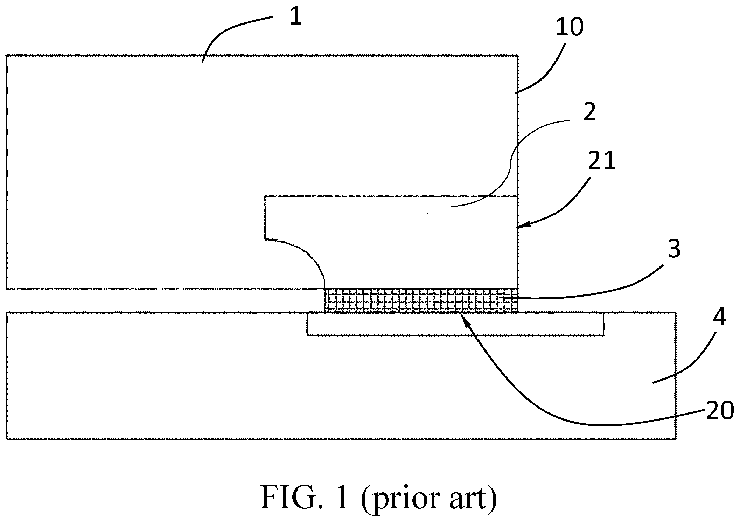

As shown in FIG. 1, a traditional package in a type of metal contacts (Input/ Output contacts) usually performs singulation on an entire unit component by cutting after a package process. After singulation, a component 1 exposes a bare copper bottom surface 20 of a lead 2 as a metal contact, and a lateral surface 21 of the lead 2 is flush with a side wall 10 of the component 1 as the metal contact. The current production merely applies a solder plating layer 3 on the bottom surface 20 of the lead 2 by electroplating. Thus, when the package unit is soldered on a circuit board 4, it is hard to determine the soldering point thereof by the appearance of the package unit based on such package configuration that replaces the conventional pins with the package in the type of metal contacts. In particular, the condition of the tin on the bottom surface 20 can merely be known by a perspective mean, such as X-ray, to determine the quality of the soldering process. In addition, metal contact of the lateral surface 21 of the lead 2 is exposed to the air and thus a non-wetting defect may be caused by oxidation.

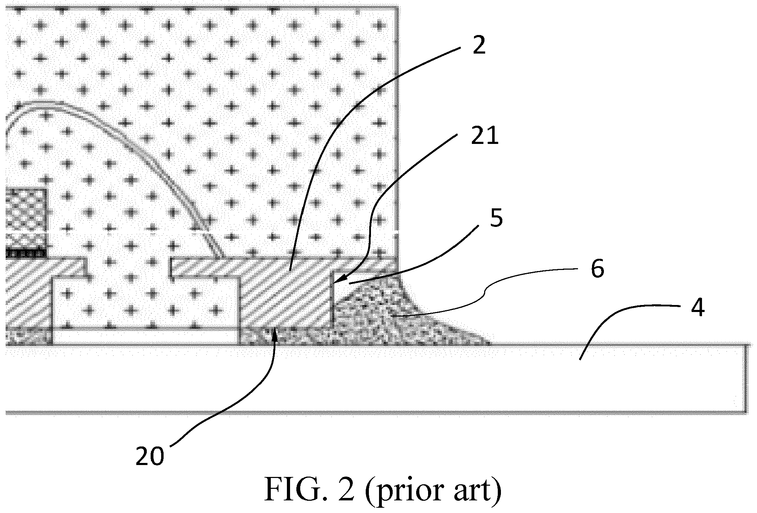

In order to solve the above issue, the lateral surface 21 of the lead 2 is wetted by solder material, thereby realizing the creepage function of the metal contact of the lateral surface of the package unit. Currently, in a regular manner, traditionally, a step cut is performed on a lead frame firstly, and the electroplating creepage as shown in FIG. 2 on a side surface on which the cutting is performed on the lead frame applies the solder material to the metal contact of the lateral surface 21 by electroplating after the cutting process, and finally the lead frame is singulated. The step cutting performed on the lead 2 is to ensure the metal units to be electrically connected in series, thereby facilitating the electroplating by maintaining complete electrical conduction. However, since step cutting or half cutting is performed on the metal connecting bar on a lateral surface, the full creepage height of the metal contact on a lateral surface can hardly be realized in the subsequent soldering process on the circuit board 4, where the creepage height of the tin material 6 depends on the cutting depth. In addition, since a half cutting is performed on the metal contact on a lateral surface, the lateral surface 21 of the lead 2 has a step potion, and when the package unit is soldered on the circuit board 4, there may easily be a risk that the creepage height at the step potion is low and a risk that air 5 remains on the step portion.

Another regular manner is to perform full cutting on the lead frame 300 firstly. To allow the lateral surface bare metal that is cut off to be covered by solder material, an electroplating process is usually performed after cutting the lead frame 300, thereby covering the exposed metal by solder material. Thus, it should be ensured that the exposed metal pad is in the series circuit. For example, as shown by a schematic view showing the traditional lead connection in FIG. 3 (US patent publication numbered US9640463), each lead 30 is connected to a metal connecting bar 31 for connecting sixteen leads 30 in series to the metal frame 32 around the same, thereby allowing the electroplating process to be performed. However, in such manner, the number of the connection bars 31 depends on the number of the leads 30, which is strict to the demand for design, has a complex manufacturing process and has low quality reliability.

Thus, an optimized cutting process and improved design of a connecting bar of the lead frame 300 are required to improve the electrical conductivity and thermal conductivity of the lead frame 300 while effectively maximizing the creepage wetting area of a metal contact on a lateral surface and ensuring the reliability of the soldering process.

US 2023/395451 A1 relates to a semiconductor device including a first lead, a second lead, a third lead, a semiconductor element, a sealing resin and a coating layer. The sealing resin has a bottom surface and an outer side surface. The bottom surface of the sealing resin is formed with a recess having an inner side surface.

US 2017/271249 A1 relates to a semiconductor device including a semiconductor chip, a plurality of leads, and a sealing resin, sealing the semiconductor chip and the leads such that lower surfaces and outer end surfaces at sides opposite the semiconductor chip of the leads are exposed.

US 2016/126162 A1 relates to a leadless packaged semiconductor device having top and bottom opposing major surfaces and sidewalls extending there between.

US 2019/244928 A1 relates to methods of forming a semiconductor package including a leadframe, coupling a semiconductor die or an electronic component to the leadframe.

US 2014/225239 A1 relates to a semiconductor device including a semiconductor element mounted on a die pad portion, a plurality of lead portions, and thin metal wires.

CN 115 172 320 A relates to the technical field of packaging lead frames and manufacturing processes.

## SUMMARY

The disclosure solves technical problems by providing a manufacturing method of a no-lead semiconductor package component, to ensure the stability and soldering quality of the soldering process when a package unit is soldered to a circuit board, so as to allow the package unit to be soldered more firmly and to simplify the inspection of the soldering quality, thereby improving the competitiveness of the package unit by reducing inspection time and cost.

In order to solve the technical problems, the disclosure uses a manufacturing method of a no-lead semiconductor package component according to claim 1. Preferred embodiments are disclosed in the dependent claims.

Due to the above technical solution, the disclosure has following advantages:

According to the manufacturing method of a no-lead semiconductor package component provided by the disclosure, the metal contacts and the X-direction metal connecting bar are connected to one another. Thus, metal pads are allowed to be formed by a half-etching process. In this way, on one hand, the soldering area of the wire bonding is enlarged. On the other hand, a cutout in step shape may be formed on the metal pads and the metal on the bottom surface. Therefore, the bonding strength of the lead and the plastic molding material is enhanced to improve the airtightness of the package component, thereby improving the stability and quality of the package unit.

In addition, all the metal contacts are in a series circuit, and the front surface and the rear surface of the chip adhered to the metal frame are connected on the metal frame via a ribbon or a clip. Thus, due to the equipotential principle, during the electroplating process, the front surface and the rear surface of the chip are in a short circuit condition, thereby realizing ESD protection function. Even though the electrical conduction on the metal frame along X-direction is disconnected by the cutting process, the disclosure further provides clamps for rack plating to form electrical connection in series, thereby simplifying the electroplating process.

## BRIEF DESCRIPTION OF THE DRAWINGS

The present disclosure will become better understood from the detailed description given herein below and the accompanying drawings which are given by way of illustration only and thus are not intended to limit the present disclosure and wherein:

FIG. 1 is a schematic view showing a traditional package of a type of metal contact;

FIG. 2 is a schematic view showing an electroplating tin material on a lateral surface where a traditional lead frame is cut;

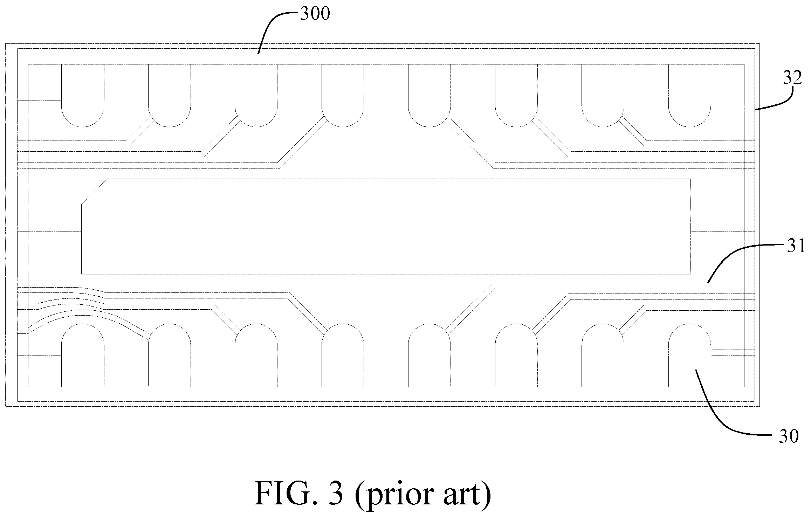

FIG. 3 is a schematic view showing a traditional lead connection;

FIG. 4 is a flow chart showing a manufacturing process of the disclosure;

FIG. 5 is a schematic view showing a wetting effect of a lateral metal contact of the disclosure;

FIG. 6 is a structural schematic view of a metal frame of the disclosure;

FIG. 7 is a rear structural schematic view showing a chip of the disclosure being mounted on the metal frame;

FIG. 8 is a rear structural schematic view of a package unit of the disclosure;

FIG. 9 is a front structural schematic view of a single package unit of the disclosure;

FIG. 10 is a schematic view showing the current during an electroplating step of the disclosure;

FIG. 11 is a side view of the package unit of the disclosure after a plastic package molding is performed thereon;

FIG. 12 is a side view showing the cutting of a Y-direction long connecting bar of the disclosure;

FIG. 13 is a side view showing that a first cutting process of the disclosure is completed;

FIG. 14 is a side view showing that a plastic molding compound of the disclosure is cut;

FIG. 15 is a side view showing that a singulation of the disclosure is complete;

FIG. 16 is a side view showing a cutting direction of the Y-direction connecting bar of the disclosure;

FIG. 17 is a side view showing a cutting direction of the Y-direction plastic molding material, X-direction metal connecting bar and plastic molding material of the disclosure;

FIG. 18 is a top view of a metal frame of embodiment 1 of the disclosure when being embodied;

FIG. 19 is a schematic view of the metal frame in FIG. 18; and

FIG. 20 is a top view of a metal frame of embodiment 2 of the disclosure when being embodied.

## DETAILED DESCRIPTION

In the following detailed description, for purposes of explanation, numerous specific details are set forth in order to provide a thorough understanding of the disclosed embodiments.

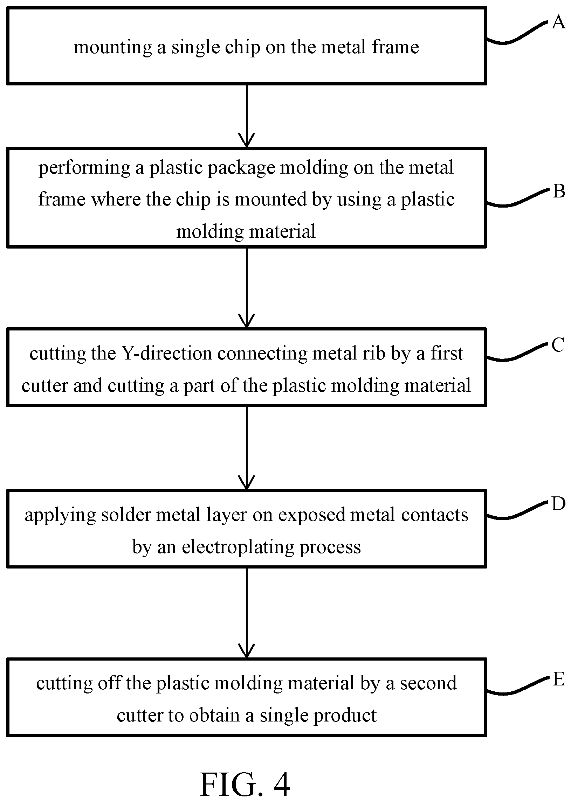

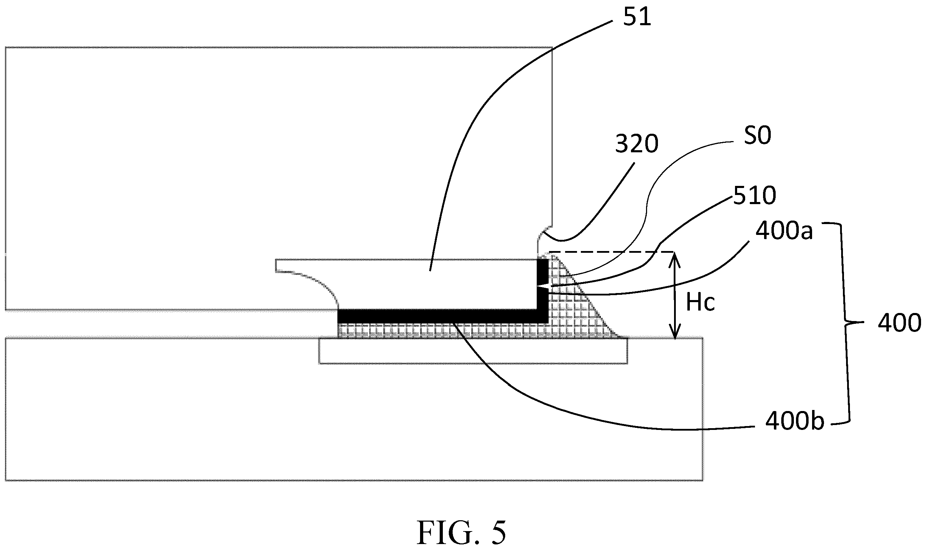

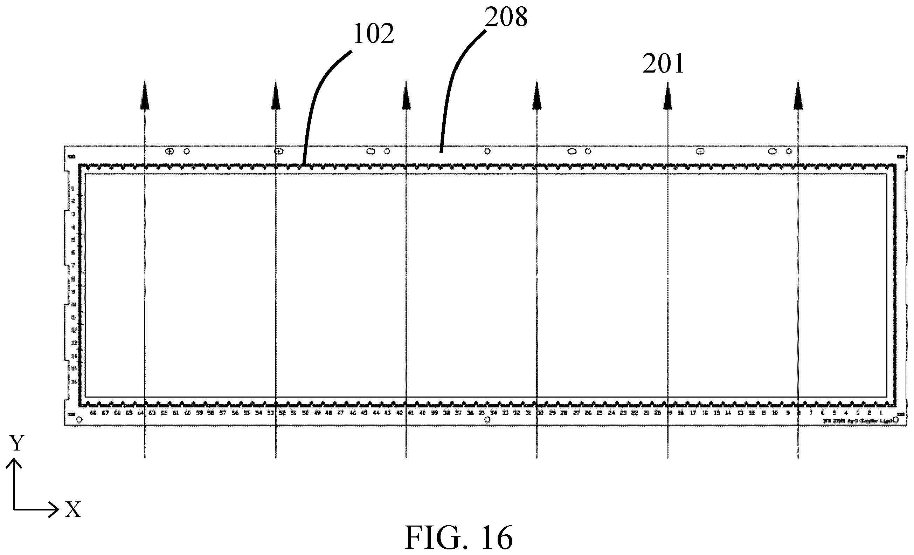

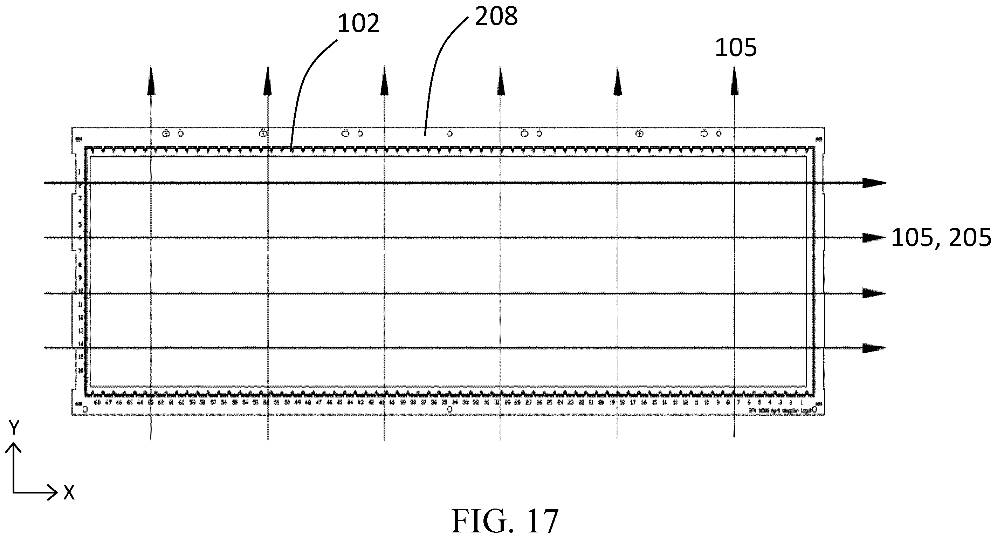

Please refer to FIG 4 showing a schematic flow chart of the disclosure, and the disclosure is further described in detail in combination with FIGS 5 to 17 and specific embodiments.

Please refer to FIG. 5 that is a cross-sectional view taken along the YZ plane. In order to allow the creepage height (Hc) to cover a height of a lateral surface 510 of a lead 51. The manufacturing method of a no-lead semiconductor package component of the disclosure is to place a wafer into a cutting machine to divide the wafer into multiple chips by a diamond cutter, laser or the like, and then perform following steps:

Step A: mounting a single chip 101 on a matrix metal frame 102, and assembling the chip 101 to the matrix metal frame 102 via, for example, bond, solder bump or the like.

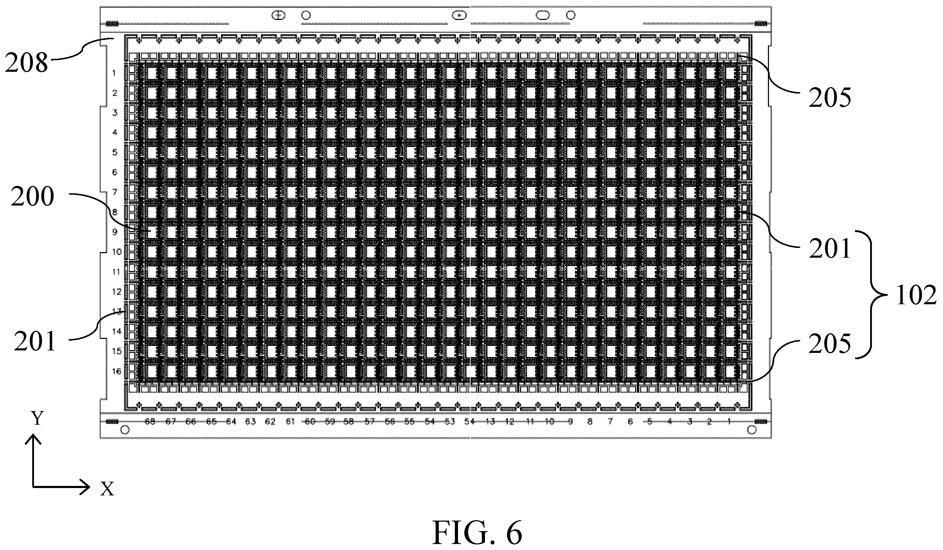

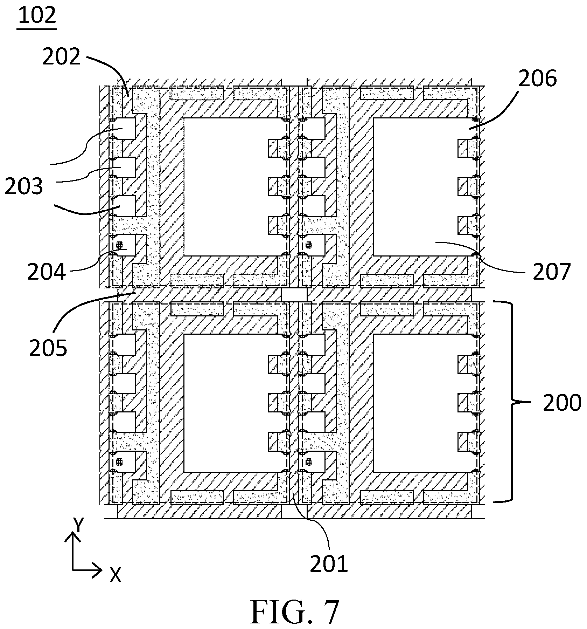

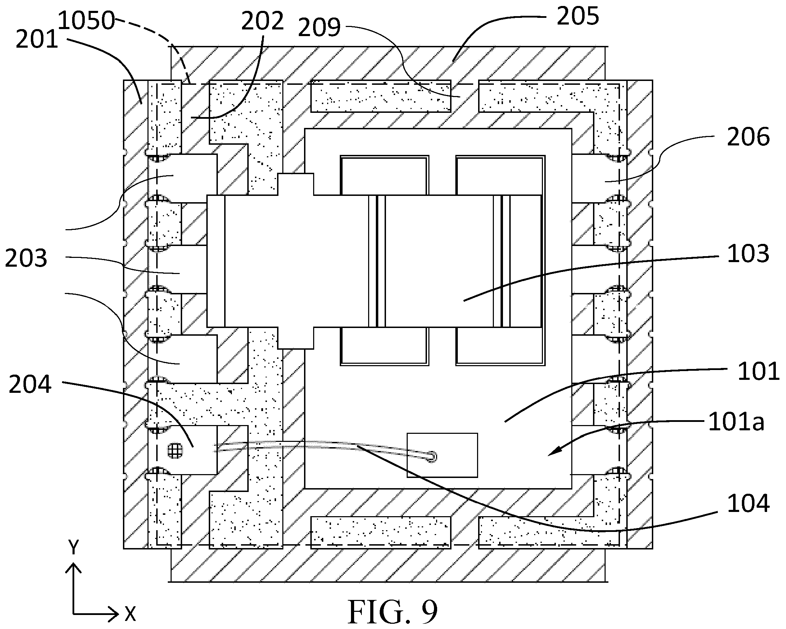

In a specific embodiment, for example, as shown in FIGS. 6, 7 and 9, a plurality of package units 200 are disposed on the matrix metal frame 102. A peripheral of the matrix metal frame 102 is not covered by the plastic molding material and exposes an edge metal frame 208. The edge metal frame 208 is in, for example, a rectangle or square frame shape to surround the matrix metal frame 102, and connects X-direction connecting bars 205 and Y-direction connecting bars 201. After the chips 101 are mounted to the matrix metal frame 102 one by one, the Y-direction connecting bars 201 are electrically connected to the chips 101 respectively by left metal contacts (including left-top metal contacts 203 and a left-bottom metal contact 204) via a ribbon or a clip, thereby configuring a package unit 200. In FIGS. 7, 9 and 10, the white parts denote a part of the matrix metal frame 102 that is not etched, the parts with section lines denote a part of the matrix metal frame 102 that is etched, and the parts with gray dots denote a part of the metal frame that is hollow. Note that the package unit 200 may be referred as a semiconductor package component. The dotted line in FIG. 9 denotes, for example, an outer edge 1050 of the package unit 200.

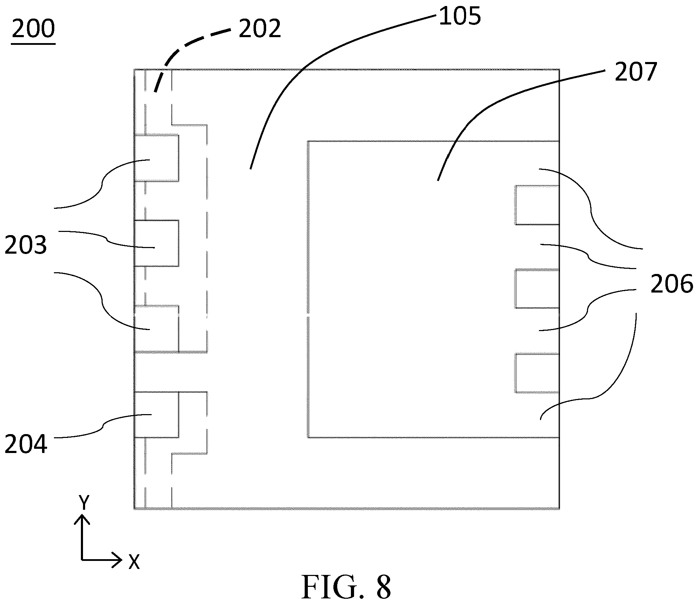

Next, referring to FIG. 8, a chip soldering area 207 is disposed inside the package unit 200. Four metal contacts are respectively disposed on left and right sides of the chip soldering area 207, including right metal contacts 206 and left metal contacts. The right metal contacts 206 are directly connected to the chip soldering area 207. Left metal contacts include three left-top metal contacts 203 connected to one another and one left-bottom metal contact 204. A short metal connecting bar 202 horizontal to the Y-direction connecting bars 201 is disposed to be connected to the left-top metal contacts 203, and another short metal connecting bar 202 is disposed to be connected to the left-bottom metal contact 204. Also, the two short metal connecting bars 202 respectively electrically connect two left metal contacts to the two X-direction connecting bars 205. The left-top metal contacts 203 and the left-bottom metal contact 204 are connected to the matrix metal frame 102 respectively via the short connecting bar 202 and the X-direction connecting bar 205. Due to such design, even though the Y-direction connecting bar 201 is cut off, the two left metal contacts still can be electrically connected to the top and bottom X-direction connecting bars 205 of the matrix metal frame 102 by the two short metal connecting bars 202. The dotted line in FIG. 8 denotes, for example, an outline of the etched part (denoted by section lines) of the Y-direction connecting bar 201 of the matrix metal frame 102 in FIG. 7.

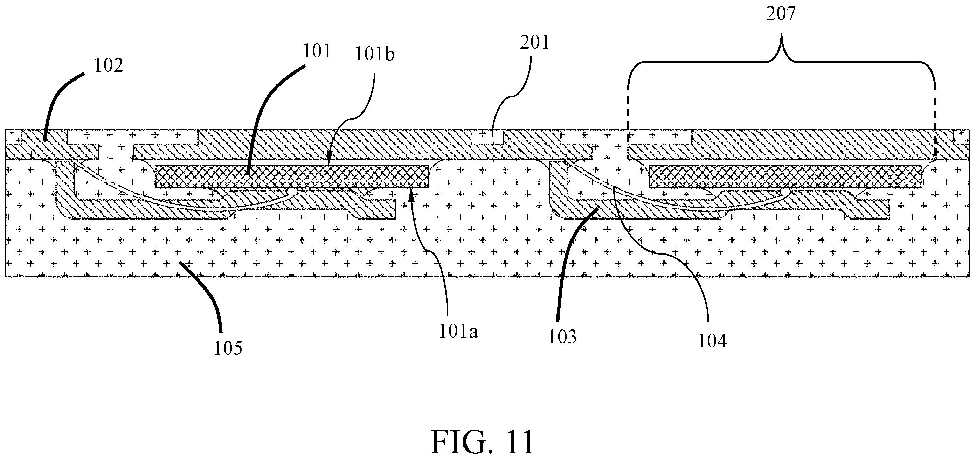

FIGS. 11 to 15 are, for example, cross-sectional views taken along the XZ plane. Please refer to FIGS. 11 and 7 for the process of mounting the chip 101 on the matrix metal frame 102. First, the chip 101 is placed on the chip soldering area 207 of a front surface of the matrix metal frame 102, and a rear surface 101b of the chip 101 is bonded or soldered to the chip soldering area 207 of the matrix metal frame 102 via a bonding or soldering process. Preferably, as shown in FIG. 9, a front surface 101a of the chip 101 and left metal contacts are respectively connected by a connecting structure, such as a clip 103 and a ribbon 104, by bonding or soldering manner.

In an embodiment, the clip 103 is preferably made of copper; the ribbon 104 is preferably made of gold, silver, copper, aluminum or an alloy. The ribbon 104 may be in a ribbon shape or a strip shape.

In an embodiment, further, by performing a half-etching technique on the three left-top metal contacts 203, a top part of the matrix metal frame 102 is removed to partially thin the matrix metal frame 102, thereby forming three metal pads whose bottom parts are connected. The matrix metal frame 102 where the half-etching is performed may enhance the bonding strength of the matrix metal frame 102 and the plastic molding material 105, and reduce the rick of the delamination of the package unit.

Step B: performing a plastic package molding on the matrix metal frame 102 where the chip 101 is mounted by using a plastic molding material 105. Note that the plastic molding material 105 is omitted from FIGS. 6 and 7.

Next, please refer to FIGS. 11 and 8. A plastic package is performed on the matrix metal frame 102 where the chip is soldered using the plastic molding material 105, and each package unit 200 is entirely surrounded by the plastic molding material 105. Each package unit 200 includes the chip 101, the metal contacts (including the left-top metal contacts 203, the left-bottom metal contact 204 and the right metal contacts 206), the ribbon 104 and the clip 103. The plastic package molding is to complete the plastic package by injecting encapsulants, and then the matrix metal frame 102 and the chip soldering area 207, the Y-direction connecting bars 201 and the X-direction connecting bars 205 located thereon are entirely surrounded by the plastic molding material 105. Only a peripheral of the matrix metal frame 102 is not surrounded by the plastic molding material, and the edge metal frame 208 is exposed to the outside to facilitate the subsequent cutting process. The plastic molding material 105 may be made of epoxy, ABF resin or other types of plastic molding material.

Step C: cutting the Y-direction connecting bar 201 and cutting a part of the plastic molding material 105 so as to expose an entire of the lateral surfaces of the metal contacts.

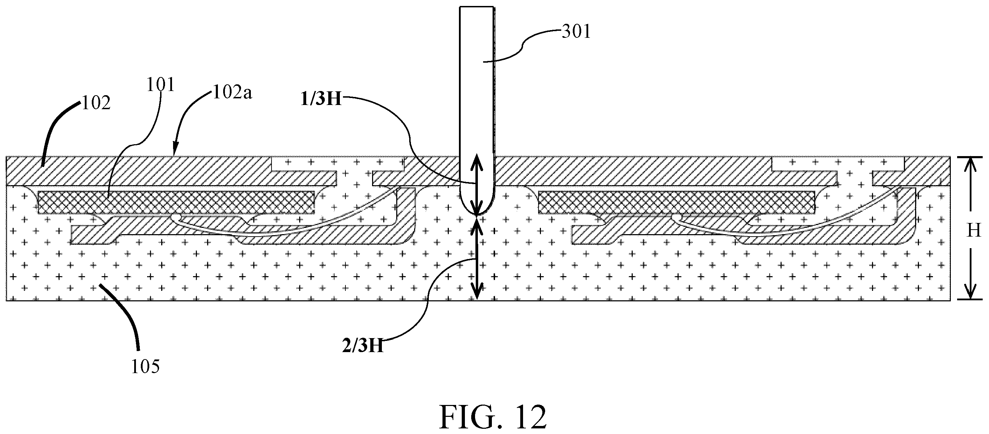

Please refer to FIGS. 12, 13 and 16. A cutter 301 is used to cut the matrix metal frame 102 surrounded by the plastic molding material 105 along a direction from a bottom surface 102a of the matrix metal frame 102 to the chip 101, to perform a vertical cut to cut off the Y-direction connecting bar 201 until a part of the plastic molding material 105 is cut without cutting off the plastic molding material 105, thereby forming a scribe line 106. A cutting depth H2 is preferably equal to 1/3 of a body thickness H of the package unit 200, and the remaining thickness H3 is 2/3 of body thickness H and forms the scribe line 106 as reference scribe line for a last singulation process. The cutter 301 cuts a part of the plastic molding material 105 to form a cutout 320 allowing the Y-direction connecting bar 201 to be entirely cut off and allowing multiple metal contacts of the Y-direction connecting bar 201 to entirely expose lateral surfaces (referring to FIG. 7).

Step D: applying solderable metal layer 400 on all exposed metal contacts and rear surface and lateral surface of the matrix metal frame 102 by an electroplating process.

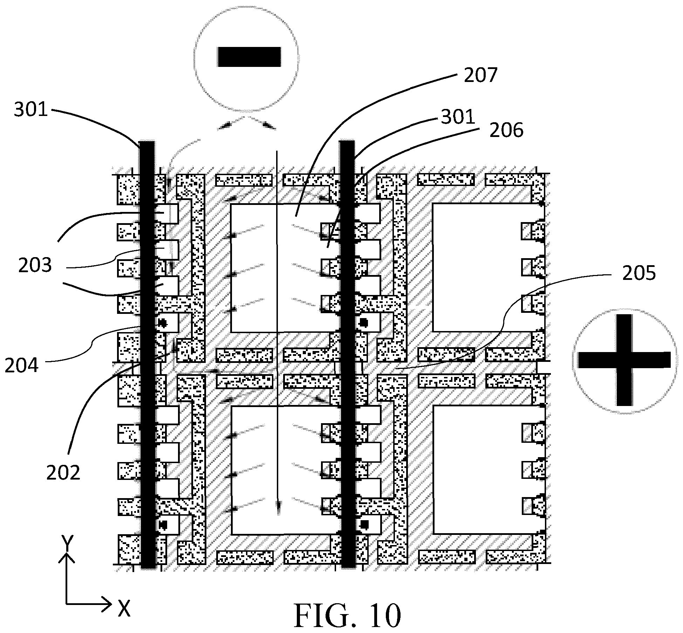

Please refer to FIG. 10. The Y-direction connecting bar 201 is entirely cut off in step C, the three left-top metal contacts 204 spaced apart from one another are electrically connected to the short metal connecting bar 202, so as to allow the current flowing from the top X-direction connecting bar 205 to form a series circuit, thereby realizing lateral and vertical electrical conduction by the left-top metal contacts 203. Also, the current flowing from the bottom X-direction connecting bar 205 flows to the left-bottom metal contact 204 through the short metal connecting bar 202, thereby realizing lateral and vertical electrical conduction. In addition, the four right metal contacts 206 located on a side of the chip soldering area 207 are also allowed to receive the current flowing from the X-direction connecting bar 205, thereby completing the electroplating. It is ensured that the left metal contacts are electrically connected to the top and bottom X-direction connecting bars 205 respectively via the two short metal connecting bars 202 even after the electrical connection along the Y-direction is disconnected after the cutting process in step C. Thus, the electrical conduction between the left metal contacts and other components are maintained so that the electroplating is allowed to be performed by a current barrel, thereby ensuring a solderable metal layer 400 to be applied to all of the metal contacts whose electrical conduction is maintained. In addition, for example, the positive label in FIG. 10 corresponds to an anode of an electroplating apparatus and the negative label in FIG. 10 correspond to a cathode of the electroplating apparatus. Even when the Y-direction connecting bars 201 are cut off, the edge metal frame 208 is still not cut off. Thus, the edge metal frame 208 respectively connects the anode and the cathode of the electroplating apparatus at different directions, so as to function as a conductive pathway for electricity on or for current to flow thereon.

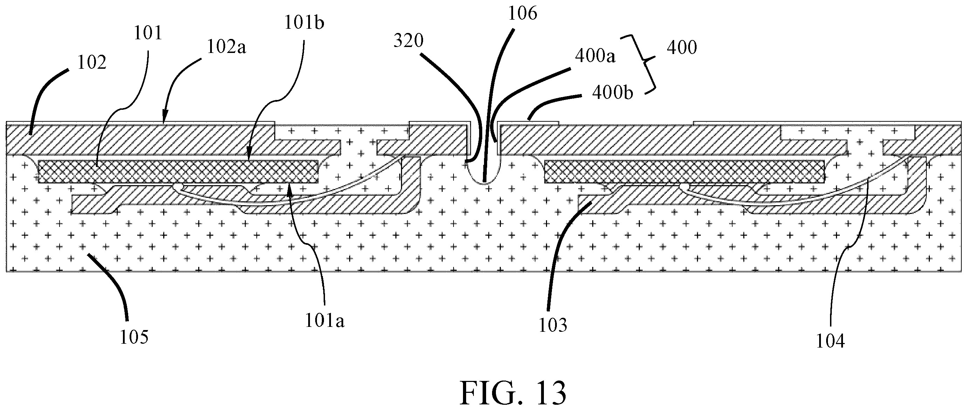

Next, please refer to FIGS. 5 and 13. The electroplating is preferably implemented by rack plating or high-speed plating, allowing a lateral solderable metal layer 400a to be applied on an entire of the lateral surface bare copper exposed after cutting the Y-direction connecting bar 201 and allowing a bottom solderable metal layer 400b to be applied and covered on the bottom surface 102a of the matrix metal frame 102.

Please refer to FIGS. 9 and 11. Furthermore, the front surface 101a of the chip 101 adhered on the matrix metal frame 102 is electrically connected to the left metal contacts 203 via the ribbon 104 or the connecting sheet 103, the left metal contacts 203 are electrically connected to the X-direction connecting bar 205 via the short metal connecting bar 202, the X-direction connecting bar 205 is electrically connected to the chip soldering area 207 via the connecting bar 209, and the rear surface 101b of the chip 101 is electrically connected to the chip soldering area 207 of the matrix metal frame 102. Thus, the front surface 101a and the rear surface 101b of the chip 101 are in a short circuit condition by the connection of the matrix metal frame 102. Due to the equipotential principle, during the electroplating process, the chip realizes ESD protection function.

Step E: cutting off the plastic molding material 105 by a thin cutter 302 to obtain a single package unit.

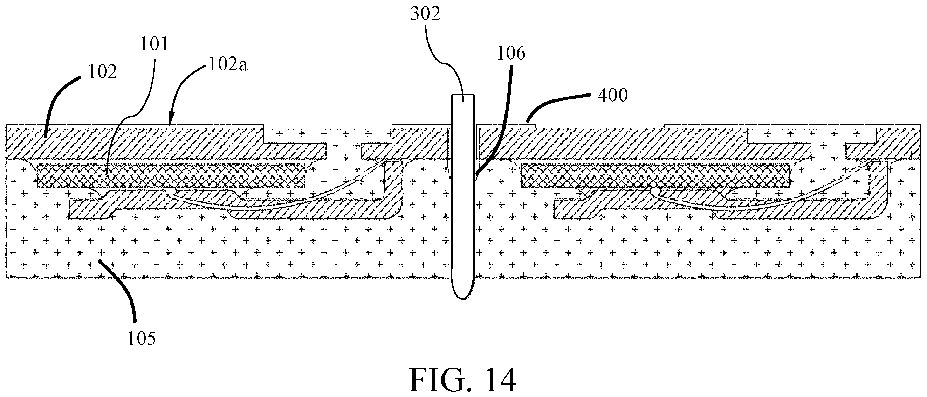

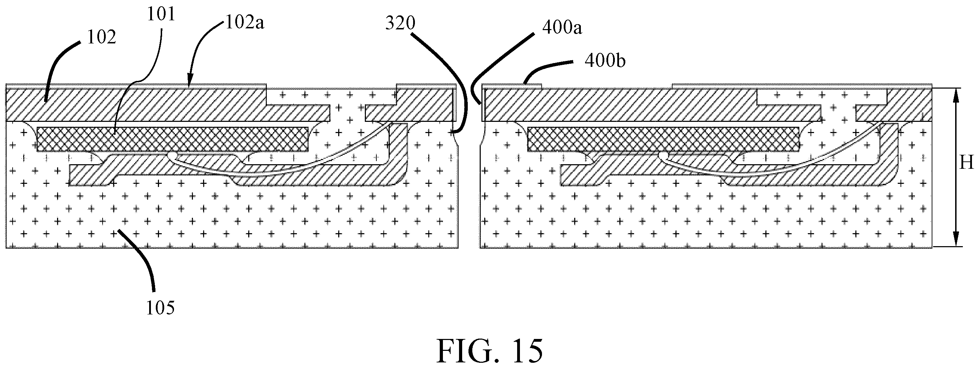

Next, please refer to FIGS. 14, 15 and 17. A full cut is performed to cut the electroplated package component by the thin cutter 302 whose diameter is smaller than the diameter of the cutter 301 preferably along the scribe line 106 from the side of the matrix metal frame 102, to entirely cut off the plastic molding material 105 along the Y-direction and entirely cut off the plastic molding material 105 and the X-direction connecting bar 205 along the X-direction. Since the diameter of the thin cutter 302 is smaller than the width of the scribe line 106, a single package unit 200 as shown in FIG. 15 is obtained after the full cut. A wall surface of the cutout 320 adjoining the plastic molding material 105 and the Y-direction connecting bar 201 are correspondingly recessed inwards along a thickness direction from the lateral solderable metal layer 400a, and the cutout 320 is located on a position at 1/3 of the body thickness H of the package unit 200, where 1/3 of the body thickness H ranges, for example, from 0.2 mm to 0.4 mm, preferably from 0.22 mm to 0.35 mm. The bottom part and lateral surface of the Y-direction connecting bar 201 both are covered with solder metal material. Thus, when a part of the bottom surface 102a and the lateral surface of the matrix metal frame 102 is wetted by solder material (referring to FIG. 5, the lead 51 in FIG. 5 corresponds to the left-top metal contact 203 exposed after the Y-direction connecting bar 201 is entirely cut off in FIG. 7), the solder material S0 covers the lateral solderable metal layer 400a and the bottom solderable metal layer 400b. Also, due to the cutout 320 recessed inwards from the peripheral wall of the plastic molding material 105, the creepage height Hc of the solder material S0 on the lead 51 along the lateral solderable metal layer 400a on the lateral surface 510 may be higher than a height of the lead 51, thereby allowing the lateral surface of the lead 51 to be entirely covered with tin material and improving the mechanical stress resistance.

Embodiment 1

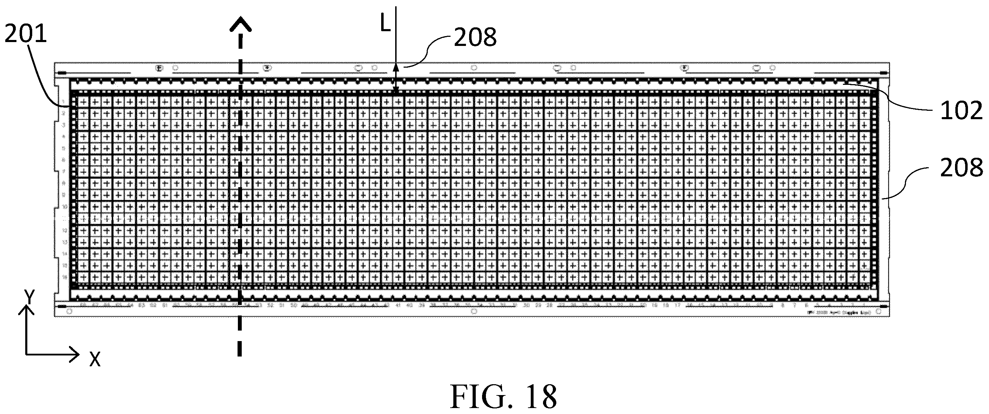

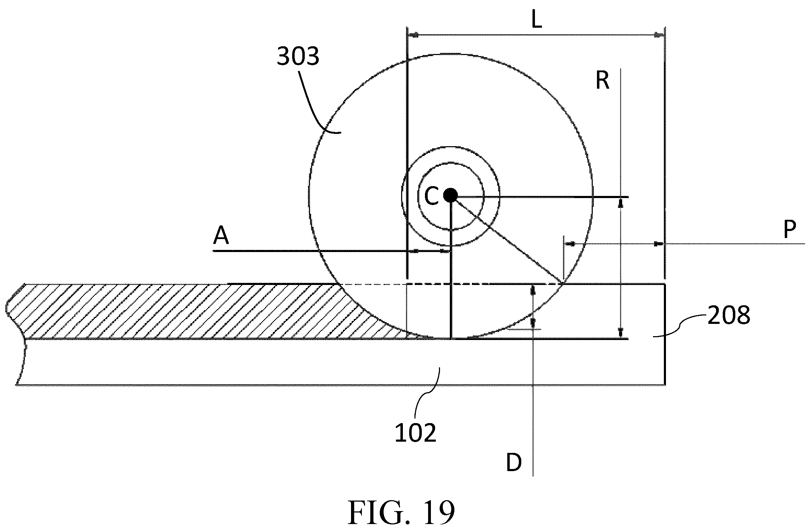

Please refer to FIG. 18. In this embodiment, a Y-direction width L of the X-direction edge metal frame 208 of the matrix metal frame 102 is wider. In step C, after cutting off the Y-direction connecting bar 201, only 1/3 of body thickness of the package unit 200 is cut and the cutting process ends, which prevents the edge metal frame 208 from being cut off. Please refer to FIG. 9. After the cutting process is completed, the left metal contacts of each unit are entirely exposed, and the left metal contacts are connected to the X-direction connecting bar 205 via the short connecting bar 202. Meanwhile, the short connecting bar 202 functions as a Y-direction connecting wire to ensure all the metal contacts are in the electrical conduction circuit along the Y-direction and each package unit 200 is connected via the rear plastic molding material 105. The rear plastic molding material 105 on the matrix metal frame 102 covered with the plastic molding material 105 is not cut off, and the X-direction edge metal frame 208 is not cut off, thereby facilitating the subsequent electroplating and second cutting step. The Y-direction width L of the X-direction edge metal frame 208 and a part of the matrix metal frame 102 is adjusted by, for example, cutting parameters to omit the clamps for rack plating. For example, as shown in FIG. 19, the Y-direction width L meets the following inequality:

$$L \geq \sqrt{R^2 - (R - D)^2} + A + P$$

In the above inequality, L is the Y-direction width L of the X-direction edge metal frame 208 and a part of the matrix metal frame 102, R is the radius of the cutter 301, D is the cutting depth of the cutter 301, A is a safety margin width, and P is the electroplating preserved width. In addition, in FIG. 19, the cutter 301 has a central point C. The radius R of the cutter 301 generally ranges from 25 mm to 35 mm. The cutting depth D generally ranges from 0.2 mm to 0.4 mm, preferably from 0.22 mm to 0.35 mm.

The safety margin width A generally ranges from 0.3 mm to 0.7 mm, preferably is 0.5 mm. The electroplating preserved width P generally ranges from 0.22 mm to 1.2 mm, preferably is 1 mm.

Embodiment 2

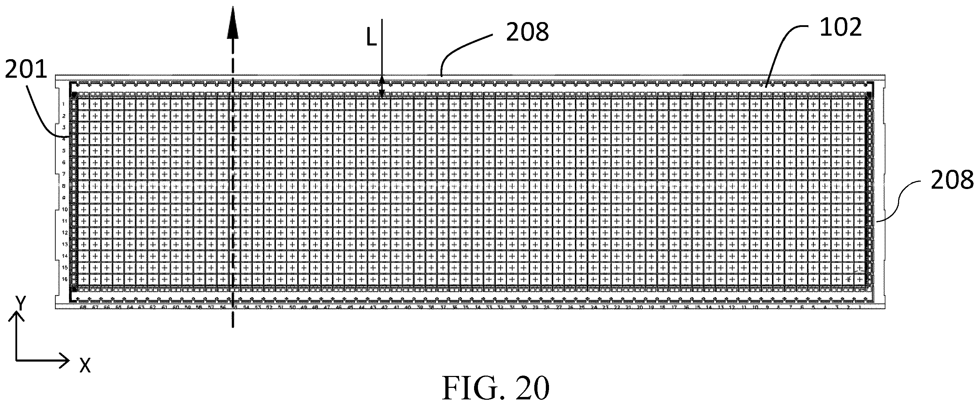

Please refer to FIG. 20. In this embodiment, the Y-direction width of the X-direction edge metal frame 208 of the matrix metal frame 102 is narrower. This embodiment is substantially the same as embodiment 1, except that: in step C, after the Y-direction connecting bar 201 is cut off, the Y-direction width of the X-direction edge metal frame 208 is too narrow (additionally referring to FIG. 19, that is, Y-direction width L meets the following inequality :

$$L \geq \sqrt{R^2 - (R - D)^2} + A + P)$$ . Thus, the edge metal frame 208 is easily cut off to destroy the electrical conduction in the subsequent electroplating process. Thus, to maintain the electrical connection of the matrix metal frame 102 in series, clamps for rack plating are used in this embodiment to clamp the X-direction edge metal frame 208 that is cut off, thereby maintaining the X-direction connecting bar 205 to be electrically connected to the two short connecting bars 202. Further, since the short connecting bar 202 is a connecting medium, even though the X-direction edge metal frame 208 is cut off, the left metal contacts may still be in the series circuit and be covered by solder metal material in the electroplating process.

In summary, the present disclosure triples a practical soldering area since the bottom parts of the left-top metal contacts 203 are electrically connected, and the heat dissipation capability of the package unit is enhanced. Meanwhile, the metal pads have a cutout in step shape, and thus the bonding strength of the metal frame and the plastic molding material is enhanced to improve the airtightness of the package component, thereby improving the stability and quality of the package unit.

**Claims**

1. A manufacturing method of a no-lead semiconductor package component (200), comprising:

   mounting a chip (101) on a metal frame (102), wherein the metal frame comprises two Y-direction connecting metal bars (201) and two X-direction connecting metal bars (205) connected to one another, each of the two Y-direction connecting metal bars is electrically connected to a plurality of metal contacts (203, 204, 206), the plurality of metal contacts at least comprise a top metal contact (203) and a bottom metal contact (204) along a Y-direction, the top metal contact and the bottom metal contact are electrically connected to the two X-direction connecting metal bars by being connected to two short metal connecting bars (202), respectively;

performing a plastic package molding on the metal frame where the chip is mounted by using a plastic molding material (105);

cutting off the Y-direction connecting bar until a part of the plastic molding material is cut without cutting off the plastic molding material by a first cutter (301) so as to allow the Y-direction connecting bar to expose an entire of lateral surfaces of the plurality of metal contacts;

wherein a Y-direction width meets an inequality:

$$ L \geq \sqrt{R^2 - (R - D)^2} + A + P $$

in the inequality, L is the Y-direction width of a X-direction edge metal frame and a part of the metal frame, R is a radius of the first cutter, D is a cutting depth of the first cutter, A is a safety margin width, and P is a electroplating preserved width, the radius of the first cutter ranges from 25 mm to 35 mm, the safety margin width ranges from 0.3 mm to 0.7 mm, and the electroplating preserved width ranges from 0.22 mm to 1.2 mm;

applying a solderable metal layer (400a) on all of the plurality of metal contacts that are exposed by an electroplating process, wherein the plurality of metal contacts further comprises four right metal contacts (206), the top metal contact comprises three left-top metal contacts (203), the bottom metal contact comprises a left-bottom metal contact (204), the two X-direction connecting metal bars comprises a top X-direction connecting metal bar (205) and a bottom X-direction connecting metal bar (205), during the electroplating process, the three left-top metal contacts spaced apart from one another are electrically connected to one of the two short metal connecting bars, so that a current flowing from the top X-direction connecting bar forms a series circuit, a current flowing from the bottom X-direction connecting bar flows to the left-bottom metal contact through another one of the two short metal connecting bars, the four right metal contacts located on a side of a chip soldering area (207) receive the current flowing from the two X-direction connecting bars; and

entirely cutting off the plastic molding material along the Y-direction and entirely cutting off the plastic molding material and the two X-direction connecting bars along a X-direction by a second cutter (302) to obtain a single semiconductor package component (200), wherein a diameter of the second cutter is smaller than a diameter of the first cutter.

2. The manufacturing method of a no-lead semiconductor package component according to claim 1, wherein in the step of the plastic package molding, a plurality of package units (200) are further disposed on the metal frame to be electrically connected to the Y-direction connecting bar and the X-direction connecting bar, the chip soldering area (207) is disposed on each of the plurality of package units, and four of the plurality of metal contacts are disposed on a left side and a right side of the chip soldering area, respectively.

3. The manufacturing method of a no-lead semiconductor package component according to claim 2, wherein in the step of mounting the chip on the metal frame, a rear surface (101b) of the chip is further bonded or soldered to the chip soldering area of the metal frame.

4. The manufacturing method of a no-lead semiconductor package component according to claim 1, wherein in the step of mounting the chip on the metal frame, a front surface (101a) of the chip is further bonded to be connected to the top metal contact by a clip (103).

5. The manufacturing method of a no-lead semiconductor package component according to claim 1, wherein in the step of mounting the chip on the metal frame, a front surface (101a) of the chip is further soldered to be connected to the bottom metal contact by a ribbon (104).

6. The manufacturing method of a no-lead semiconductor package component according to claim 1, wherein in the step of cutting the Y-direction connecting bar by the first cutter, a cutting depth (H2) is equal to 1/3 of a thickness (H) of the semiconductor package component.

7. The manufacturing method of a no-lead semiconductor package component according to claim 1, wherein in the step of cutting the Y-direction connecting bar by the first cutter, the Y-direction connecting bar is further cut until a part of the plastic molding material is cut to form a cutout (320) along a direction from the side of the metal frame to the plastic molding material, the cutout entirely cuts off the Y-direction connecting bar and does not cut off the plastic molding material.

8. The manufacturing method of a no-lead semiconductor package component according to claim 7, wherein the cutout of the plastic molding material adjoins the Y-direction connecting bar, and the cutout is correspondingly recessed inwards along a thickness direction from the solderable metal layer from a peripheral wall of the plastic molding material.

9. The manufacturing method of a no-lead semiconductor package component according to claim 1, wherein in the step of electroplating, the solderable metal layer is further formed on a bottom surface (102a) of the metal frame.

10. The manufacturing method of a no-lead semiconductor package component according to claim 3, wherein after the step of being bonded or soldered to the metal frame, a bottom part of the metal frame is thinned by a half-etching.

11. The manufacturing method of a no-lead semiconductor package component according to claim 1, wherein in the step of electroplating, the solderable metal layer is further formed on an exposed lateral surface of the metal frame.

12. The manufacturing method of a no-lead semiconductor package component according to claim 1, wherein in the step of electroplating, a bottom solderable metal layer (400b) is further formed on a bottom part of the Y-direction connecting metal bar, and a lateral solderable metal layer (400a) is further formed on a lateral surface of the Y-direction connecting metal bar.

13. The manufacturing method of a no-lead semiconductor package component according to claim 12, wherein a creepage height (Hc) of the lateral solderable metal layer is higher than a thickness of the metal frame.

14. The manufacturing method of a no-lead semiconductor package component according to claim 12, wherein the cutout of the plastic molding material is correspondingly recessed inwards from the side solderable metal layer.

15. The manufacturing method of a no-lead semiconductor package component according to claim 1, wherein in the step of electroplating, a device for rack plating is further used to clamp the metal frame of X-direction.

16. The manufacturing method of a no-lead semiconductor package component according to claim 1, wherein in the step of electroplating, a device for rack plating is further used to realize an electrical conduction of the X-direction connecting metal bar.

17. The manufacturing method of a no-lead semiconductor package component according to claim 1, wherein in the step of cutting the Y-direction connecting bar by the first cutter, the plastic molding material is not cut off to form a scribe line (106), and the diameter of the second cutter is smaller than a width of the scribe line.

18. The manufacturing method of a no-lead semiconductor package component according to claim 4, wherein in the step of the plastic package molding, the plastic molding material surrounds the chip, the plurality of metal contacts and the clip.

19. The manufacturing method of a no-lead semiconductor package component according to claim 5, wherein in the step of the plastic package molding, the plastic molding material surrounds the chip, the plurality of metal contacts and the ribbon.

## Patentansprüche

1. Herstellungsverfahren einer bleifreien Halbleitergehäusekomponente (200), umfassend:

Montieren eines Chips (101) auf einem Metallrahmen (102), wobei der Metallrahmen zwei in Y-Richtung verlaufende Verbindungsmetallstangen (201) und zwei in X-Richtung verlaufende Verbindungsmetallstangen (205) umfasst, die miteinander verbunden sind, wobei jede der beiden in Y-Richtung verlaufenden Verbindungsmetallstangen elektrisch mit einer Vielzahl von Metallkontakten (203, 204, 206) verbunden ist, wobei die Vielzahl von Metallkontakten mindestens einen oberen Metallkontakt (203) und einen unteren Metallkontakt (204) entlang einer Y-Richtung umfasst, wobei der obere Metallkontakt und der untere Metallkontakt elektrisch mit den beiden in X-Richtung verlaufenden Verbindungsmetallstangen verbunden sind, indem sie jeweils mit zwei kurzen Metallverbindungsstangen (202) verbunden sind;
Durchführen eines Kunststoffgehäuseformens an dem Metallrahmen, auf dem der Chip montiert ist, unter Verwendung eines Kunststoffformmaterials (105);
Abschneiden der in Y-Richtung verlaufenden Verbindungsstange, bis ein Teil des Kunststoffformmaterials geschnitten ist, ohne das Kunststoffformmaterial mit einem ersten Schneidwerkzeug (301) abzuschneiden, so dass die in Y-Richtung verlaufende Verbindungsstange die gesamten Seitenflächen der Vielzahl von Metallkontakten freilegt;
wobei eine in Y-Richtung verlaufende Breite eine Ungleichung erfüllt:

$$L \geq \sqrt{R^2 - (R-D)^2} + A + P$$

in der Ungleichung ist L die in y-Richtung verlaufende Breite eines in X-Richtung verlaufenden Kantenmetallrahmens und eines Teils des Metallrahmens, ist R ein Radius des ersten Schneidwerkzeugs, ist D eine Schnitttiefe des ersten Schneidwerkzeugs, ist A eine Sicherheitsabstandsbreite, und ist P eine galvanisch erhaltene Breite, wobei der Radius des ersten Schneidwerkzeugs im Bereich von 25 mm bis 35 mm liegt, die Sicherheitsabstandsbreite im Bereich von 0,3 mm bis 0,7 mm liegt, und die galvanisch erhaltene Breite im Bereich von 0,22 mm bis 1,2 mm liegt;

Aufbringen einer lötbaren Metallschicht (400a) auf alle der Vielzahl von Metallkontakten, die durch einen Galvanisierungsprozess freigelegt werden, wobei die Vielzahl von Metallkontakten ferner vier rechte Metallkontakte (206) umfasst, der obere Metallkontakt drei linke obere Metallkontakte (203) umfasst, der untere Metallkontakt einen linken unteren Metallkontakt (204) umfasst, die zwei in X-Richtung verlaufenden Verbindungsmetallstangen eine obere in X-Richtung verlaufende Verbindungsmetallstange (205) und eine untere in X-Richtung verlaufende Verbindungsmetallstange (205) umfassen, während des Galvanisierungsprozesses, werden die drei voneinander beabstandeten linken oberen Metallkontakte elektrisch mit einem der beiden kurzen Metallverbindungsstangen verbunden, sodass ein von der oberen in X-Richtung verlaufenden Verbindungsstange fließender Strom einen Serienschaltkreis bildet, ein von der unteren in X-Richtung verlaufenden Verbindungsstange fließender Strom über eine weitere der beiden kurzen Metallverbindungsstangen zum linken unteren Metallkontakt fließt, die vier rechten Metallkontakte, die sich an einer Seite eines Chip-Lötbereichs (207) befinden, den von den beiden in X-Richtung verlaufenden Verbindungsstangen fließenden Strom aufnehmen; und

vollständiges Abschneiden des Kunststoffformmaterials entlang der Y-Richtung und vollständiges Abschneiden des Kunststoffformmaterials sowie die zwei in X-Richtung verlaufenden Verbindungsstangen mit einem zweiten Schneidwerkzeug (302), um eine einzelne Halbleitergehäusekomponente (200) zu erhalten, wobei ein Durchmesser des zweiten Schneidwerkzeugs kleiner ist als ein Durchmesser des ersten Schneidwerkzeugs.

2. Herstellungsverfahren einer bleifreien Halbleitergehäusekomponente gemäß Anspruch 1, wobei im Schritt des Kunststoffgehäuseformens eine Vielzahl von Gehäuseeinheiten (200) ferner auf dem Metallrahmen angeordnet sind, um elektrisch mit der in Y-Richtung verlaufenden Verbindungsstange und der in X-Richtung verlaufenden Verbindungsstange verbunden zu werden, wobei der Chip-Lötbereich (207) auf jeder der Vielzahl von Gehäuseeinheiten angeordnet ist, und wobei vier der Vielzahl von Metallkontakten jeweils auf einer linken Seite und einer rechten Seite des Chip-Lötbereichs angeordnet sind.

3. Herstellungsverfahren einer bleifreien Halbleitergehäusekomponente gemäß Anspruch 2, wobei im Schritt des Montierens des Chips auf dem Metallrahmen eine Rückseite (101b) des Chips ferner mit dem Chip-Lötbereich des Metallrahmens verbunden oder verlötet wird.

4. Herstellungsverfahren einer bleifreien Halbleitergehäusekomponente gemäß Anspruch 1, wobei im Schritt des Montierens des Chips auf den Metallrahmen eine Vorderseite (101a) des Chips ferner durch einen Clip (103) mit dem oberen Metallkontakt verbunden wird.

5. Herstellungsverfahren einer bleifreien Halbleitergehäusekomponente gemäß Anspruch 1, wobei in dem Schritt des Montierens des Chips auf den Metallrahmen eine Vorderseite (101a) des Chips ferner verlötet wird, um über ein Band (104) mit dem unteren Metallkontakt verbunden zu werden.

6. Herstellungsverfahren einer bleifreien Halbleitergehäusekomponente gemäß Anspruch 1, wobei im Schritt des Schneidens der in Y-Richtung verlaufenden Verbindungsstange durch das erste Schneidwerkzeug eine Schnitttiefe (H2) gleich 1/3 der Dicke (H) der Halbleitergehäusekomponente ist.

7. Herstellungsverfahren einer bleifreien Halbleitergehäusekomponente gemäß Anspruch 1, wobei im Schritt des Schneidens der in Y-Richtung verlaufenden Verbindungsstange mit dem ersten Schneidwerkzeug die in Y-Richtung verlaufende Verbindungsstange weiter geschnitten wird, bis ein Teil des Kunststoffformmaterials geschnitten ist, um einen Ausschnitt (320) entlang einer Richtung von der Seite des Metallrahmens zum Kunststoffformmaterial zu bilden, wobei der Ausschnitt die in Y-Richtung verlaufende Verbindungsstange vollständig abschneidet und das Kunststoffformmaterial nicht abschneidet.

8. Herstellungsverfahren einer bleifreien Halbleitergehäusekomponente gemäß Anspruch 7, wobei der Ausschnitt des Kunststoffformmaterials an die in Y-Richtung verlaufende Verbindungsstange angrenzt, und der Ausschnitt entlang einer Dickenrichtung von der lötbaren Metallschicht von einer Umfangswand des Kunststoffformmaterials entsprechend nach innen vertieft ist.

9. Herstellungsverfahren einer bleifreien Halbleitergehäusekomponente gemäß Anspruch 1, wobei im Schritt des Galvanisierens die lötbare Metallschicht ferner auf einer Unterseite (102a) des Metallrahmens gebildet wird.

10. Herstellungsverfahren einer bleifreien Halbleitergehäusekomponente gemäß Anspruch 3, wobei nach dem Schritt des Bondens oder Lötens an den Metallrahmen ein unterer Teil des Metallrahmens durch ein Halbätzen verdünnt wird.

11. Herstellungsverfahren einer bleifreien Halbleitergehäusekomponente gemäß Anspruch 1, wobei im Schritt des Galvanisierens die lötbare Metallschicht ferner auf einer freiliegenden Seitenfläche des Metallrahmens gebildet wird.

12. Herstellungsverfahren einer bleifreien Halbleitergehäusekomponente gemäß Anspruch 1, wobei im Schritt des Galvanisierens ferner eine untere lötbare Metallschicht (400b) auf einem unteren Abschnitt der in Y-Richtung verlaufenden Verbindungsmetallstange und eine seitliche lötbare Metallschicht (400a) auf einer Seitenfläche der in Y-Richtung verlaufenden Verbindungsmetallstange gebildet wird.

13. Herstellungsverfahren eines bleifreien Halbleitergehäusebauteils gemäß Anspruch 12, wobei die Kriechhöhe (Hc) der seitlichen lötbaren Metallschicht höher ist als die Dicke des Metallrahmens.

14. Herstellungsverfahren einer bleifreien Halbleitergehäusekomponente gemäß Anspruch 12, wobei der Ausschnitt des Kunststoffformmaterials gemäß der seitlichen lötbaren Metallschicht nach innen versetzt ist.

15. Herstellungsverfahren einer bleifreien Halbleitergehäusekomponente gemäß Anspruch 1, wobei im Schritt des Galvanisierens ferner eine Vorrichtung zum Gestellgalvanisieren verwendet wird, um den Metallrahmen in X-Richtung festzuklemmen.

16. Herstellungsverfahren einer bleifreien Halbleitergehäusekomponente gemäß Anspruch 1, wobei im Schritt des Galvanisierens ferner eine Vorrichtung zum Gestellgalvanisieren verwendet wird, um die elektrische Leitfähigkeit der in X-Richtung verlaufenden Verbindungsmetallstange herzustellen.

17. Herstellungsverfahren einer bleifreien Halbleitergehäusekomponente gemäß Anspruch 1, wobei bei dem Schritt des Schneidens der in Y-Richtung verlaufenden Verbindungsstange durch das erste Schneidwerkzeug das Kunststoffformmaterial nicht vollständig durchtrennt wird, um eine Ritzlinie (106) zu bilden, und der Durchmesser des zweiten Schneidwerkzeugs kleiner ist als die Breite der Ritzlinie.

18. Herstellungsverfahren einer bleifreien Halbleitergehäusekomponente gemäß Anspruch 4, wobei im Schritt des Kunststoffgehäuseformens das Kunststoffformmaterial den Chip, die Vielzahl von Metallkontakten und die Klammer umgibt.

19. Herstellungsverfahren einer bleifreien Halbleitergehäusekomponente gemäß Anspruch 5, wobei im Schritt des Kunststoffgehäuseformens das Kunststoffformmaterial den Chip, die Vielzahl von Metallkontakten und das Band umgibt.

**Revendications**

1. Procédé de fabrication d'un composant de boîtier de semi-conducteur sans broches (200), consistant à :

monter une puce (101) sur un cadre métallique (102), le cadre métallique comprenant deux barres de connexion métalliques (201) de direction Y et deux barres de connexion métalliques (205) de direction X, connectées les unes aux autres, chacune des deux barres de connexion métalliques de direction Y étant connectée électriquement à une pluralité de contacts métalliques (203, 204, 206), la pluralité de contacts métalliques comprenant au moins un contact métallique supérieur (203) et un contact métallique inférieur (204) le long d'une direction Y, le contact métallique supérieur et le contact métallique inférieur étant connectés électriquement aux deux barres de connexion métalliques de direction X en étant connectés respectivement à deux courtes barres de connexion métalliques (202) ;
réaliser un moulage de boîtier en plastique sur le cadre métallique, où la puce est montée, en utilisant un matériau de moulage en plastique (105) ;
couper la barre de connexion de direction Y jusqu'à ce qu'une partie du matériau de moulage en plastique soit découpée, sans couper le matériau de moulage en plastique lui-même, à l'aide d'une première lame de coupe (301), de manière à permettre à la barre de connexion de direction Y de dégager l'intégralité des surfaces latérales de la pluralité de contacts métalliques ;
sachant qu'une largeur de direction Y satisfait à l'inégalité :

$$L \geq \sqrt{R^2 - (R - D)^2} + A + P$$

dans l'inégalité, *L* représente la largeur de direction Y d'un cadre métallique de bord de direction X et d'une partie du cadre métallique, *R* représente le rayon de la première lame de coupe, *D* représente la profondeur de coupe de la première lame de coupe, A représente la largeur de la marge de sécurité, et *P* représente la largeur préservée à la galvanoplastie, le rayon de la première lame de coupe est compris entre 25 mm et 35 mm, la largeur de la marge de sécurité est comprise entre 0,3 mm et 0,7 mm, et la largeur préservée à la galvanoplastie est comprise entre 0,22 mm et 1,2 mm ;

appliquer une couche métallique soudable (400a) sur l'ensemble de la pluralité de contacts métalliques dégagés par un procédé de galvanoplastie, sachant que la pluralité de contacts métalliques comprend en outre quatre contacts métalliques droits (206), le contact métallique supérieur comprend trois contacts métalliques supérieurs gauches (203), le contact métallique inférieur comprend un contact métallique inférieur gauche (204), les deux barres de connexion métalliques de direction X comprennent une barre de connexion métallique de direction X (205) supérieure et une barre de connexion métallique de direction X (205) inférieure, au cours du procédé de galvanoplastie, les trois contacts métalliques supérieurs gauches espacés les uns des autres sont connectés électriquement à l'une parmi les deux barres de connexion métalliques courtes, de sorte qu'un courant circulant depuis la barre de connexion de direction X supérieure forme un circuit en série, un courant circulant depuis la barre de connexion de direction X inférieure circule vers le contact métallique inférieur gauche via une autre parmi les deux barres de connexion métalliques courtes, les quatre contacts métalliques droits situés sur un côté d'une zone de soudure de puce (207) reçoivent le courant circulant depuis les deux barres de connexion de direction X ; et

couper entièrement le matériau de moulage en plastique le long de la direction Y et couper entièrement le matériau de moulage en plastique et les deux barres de connexion de direction X le long de la direction X à l'aide d'une deuxième lame de coupe (302) afin d'obtenir un composant de boîtier de semi-conducteur unique (200), le diamètre de la deuxième lame de coupe étant inférieur au diamètre de la première lame de coupe.

2. Procédé de fabrication d'un composant de boîtier de semi-conducteur sans broches selon la revendication 1,
dans lequel, lors de l'étape de moulage du boîtier en plastique, une pluralité d'unités de boîtier (200) sont en outre disposées sur le cadre métallique pour être connectées électriquement à la barre de connexion de direction Y et à la barre de connexion de direction X, la zone de soudure de puce (207) est disposée sur chacune parmi la pluralité d'unités de boîtier, et quatre parmi la pluralité de contacts métalliques sont disposés respectivement sur un côté gauche et un côté droit de la zone de soudure de puce.

3. Procédé de fabrication d'un composant de boîtier de semi-conducteur sans broches selon la revendication 2,
dans lequel, lors de l'étape de montage de la puce sur le cadre métallique, une surface arrière (101b) de la puce est en outre collée ou soudée à la zone de soudure de puce du cadre métallique.

4. Procédé de fabrication d'un composant de boîtier de semi-conducteur sans broches selon la revendication 1,
dans lequel, lors de l'étape de montage de la puce sur le cadre métallique, une surface avant (101a) de la puce est en outre collée pour être connectée au contact métallique supérieur par un clip (103).

5. Procédé de fabrication d'un composant de boîtier de semi-conducteur sans broches selon la revendication 1,
dans lequel, lors de l'étape de montage de la puce sur le cadre métallique, une surface avant (101a) de la puce est en outre soudée pour être connectée au contact métallique inférieur par un ruban (104).

6. Procédé de fabrication d'un composant de boîtier de semi-conducteur sans broches selon la revendication 1,
dans lequel, lors de l'étape de coupe de la barre de connexion de direction Y par la première lame de coupe, une profondeur de coupe (H2) est égale à 1/3 de l'épaisseur (H) du composant de boîtier de semi-conducteur.

7. Procédé de fabrication d'un composant de boîtier de semi-conducteur sans broches selon la revendication 1,
dans lequel, lors de l'étape de coupe de la barre de connexion de direction Y par la première lame de coupe, la barre de connexion de direction Y est en outre coupée jusqu'à ce qu'une partie du matériau de moulage en plastique soit découpée pour former une découpe (320) le long d'une direction allant du côté du cadre métallique vers le matériau de moulage en plastique, la découpe coupant entièrement la barre de connexion de direction Y sans couper le matériau de moulage en plastique.

8. Procédé de fabrication d'un composant de boîtier de semi-conducteur sans broches selon la revendication 7,

dans lequel la découpe du matériau de moulage en plastique est adjacente à la barre de connexion de direction Y, et la découpe est en retrait vers l'intérieur le long d'une direction d'épaisseur à partir de la couche métallique soudable, à partir d'une paroi périphérique du matériau de moulage en plastique.

9. Procédé de fabrication d'un composant de boîtier de semi-conducteur sans broches selon la revendication 1,

dans lequel, lors de l'étape de galvanoplastie, la couche métallique soudable est en outre formée sur une surface inférieure (102a) du cadre métallique.

10. Procédé de fabrication d'un composant de boîtier de semi-conducteur sans broches selon la revendication 3,

dans lequel, après l'étape de collage ou de soudage au cadre métallique, une partie inférieure du cadre métallique est amincie par une semi-gravure.

11. Procédé de fabrication d'un composant de boîtier de semi-conducteur sans broches selon la revendication 1,

dans lequel, lors de l'étape de galvanoplastie, la couche métallique soudable est en outre formée sur une surface latérale dégagée du cadre métallique.

12. Procédé de fabrication d'un composant de boîtier de semi-conducteur sans broches selon la revendication 1,

dans lequel, lors de l'étape de galvanoplastie, une couche métallique soudable inférieure (400b) est en outre formée sur une partie inférieure de la barre de connexion métallique de direction Y, et une couche métallique soudable latérale (400a) est en outre formée sur une surface latérale de la barre de connexion métallique de direction Y.

13. Procédé de fabrication d'un composant de boîtier de semi-conducteur sans broches selon la revendication 12,

dans lequel la hauteur de ligne de fuite (Hc) de la couche métallique soudable latérale est supérieure à l'épaisseur du cadre métallique.

14. Procédé de fabrication d'un composant de boîtier de semi-conducteur sans broches selon la revendication 12,

dans lequel la découpe du matériau de moulage en plastique est en retrait vers l'intérieur par rapport à la couche métallique soudable latérale.

15. Procédé de fabrication d'un composant de boîtier de semi-conducteur sans broches selon la revendication 1,

dans lequel, lors de l'étape de galvanoplastie, un dispositif de placage en rack est en outre utilisé pour serrer le cadre métallique de direction X.

16. Procédé de fabrication d'un composant de boîtier de semi-conducteur sans broches selon la revendication 1,

dans lequel, lors de l'étape de galvanoplastie, un dispositif de placage en rack est en outre utilisé pour réaliser une conduction électrique de la barre de connexion métallique de direction X.

17. Procédé de fabrication d'un composant de boîtier de semi-conducteur sans broches selon la revendication 1,

dans lequel, lors de l'étape de coupe de la barre de connexion de direction Y par la première lame de coupe, le matériau de moulage plastique n'est pas coupé pour former une ligne de traçage (106), et le diamètre de la deuxième lame de coupe est inférieur à la largeur de la ligne de traçage.

18. Procédé de fabrication d'un composant de boîtier de semi-conducteur sans broches selon la revendication 4,

dans lequel, lors de l'étape de moulage du boîtier en plastique, la matière de moulage en plastique entoure la puce, la pluralité de contacts métalliques et le clip.

19. Procédé de fabrication d'un composant de boîtier de semi-conducteur sans broches selon la revendication 5,

dans lequel, lors de l'étape de moulage du boîtier en plastique, la matière de moulage en plastique entoure la puce, la pluralité de contacts métalliques et le ruban.

FIG. 1 (prior art)

EP 4 641 622 B1

FIG. 2 (prior art)

FIG. 3 (prior art)

```
┌─────────────────────────────────────────────────┐
│                                                 │  A
│        mounting a single chip on the metal frame │
│                                                 │
└─────────────────────────────────────────────────┘
                        │
                        ▼
┌─────────────────────────────────────────────────┐
│     performing a plastic package molding on the metal │
│     frame where the chip is mounted by using a plastic │  B
│                 molding material                │
└─────────────────────────────────────────────────┘
                        │
                        ▼
┌─────────────────────────────────────────────────┐
│     cutting the Y-direction connecting metal rib by a first │  C
│   cutter and cutting a part of the plastic molding material │
└─────────────────────────────────────────────────┘
                        │
                        ▼
┌─────────────────────────────────────────────────┐
│     applying solder metal layer on exposed metal contacts │  D
│                 by an electroplating process    │
└─────────────────────────────────────────────────┘
                        │
                        ▼
┌─────────────────────────────────────────────────┐
│     cutting off the plastic molding material by a second │  E
│            cutter to obtain a single product    │
└─────────────────────────────────────────────────┘
```

FIG. 4

FIG. 5

EP 4 641 622 B1

FIG. 6

EP 4 641 622 B1

FIG. 7

EP 4 641 622 B1

FIG. 8

EP 4 641 622 B1

FIG. 9

EP 4 641 622 B1

FIG. 10

FIG. 11

EP 4 641 622 B1

FIG. 12

FIG. 13

FIG. 14

EP 4 641 622 B1

FIG. 15

EP 4 641 622 B1

FIG. 16

FIG. 17

FIG. 18

FIG. 19

FIG. 20

**EP 4 641 622 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 9640463 B
- US 2023395451 A1
- US 2017271249 A1
- US 2016126162 A1
- US 2019244928 A1
- US 2014225239 A1
- CN 115172320 A